# EUROPÄISCHE PATENTSCHRIFT

(11) **EP 2 729 840 B1**
(45) Veröffentlichungstag und Bekanntmachung des Hinweises auf die Patenterteilung: **08.05.2019**
(21) Anmeldenummer: 12738056.6
(22) Anmeldetag: 05.07.2012
(51) Int. Cl.: G02B 19/00, F21V 7/00, H01L 33/58, F21V 5/00, G02B 27/09, B29C 45/00, B29D 11/00

(54) **LICHTBEEINFLUSSUNGSELEMENT ZUR BEEINFLUSSUNG DER LICHTABGABE VON IM WESENTLICHEN PUNKTFÖRMIGEN LICHTQUELLEN**
LIGHT-INFLUENCING ELEMENT FOR INFLUENCING THE LIGHT EMISSION OF ESSENTIALLY POINT LIGHT SOURCES
ÉLÉMENT INFLUANT SUR LA LUMIÈRE, SERVANT À INFLUER SUR L'ÉMISSION DE LUMIÈRE DE SOURCES LUMINEUSES SENSIBLEMENT EN FORME DE POINTS

(30) Priorität: 08.07.2011 DE 102011078865; 27.10.2011 DE 102011085291
(43) Veröffentlichungstag der Anmeldung: 14.05.2014
(73) Patentinhaber: Zumtobel Lighting GmbH, 6850 Dornbirn (AT)
(72) Erfinder: EBNER, Stephan, A-6850 Dornbirn (AT); GASSNER, Patrik, A-6722 St. Gerold (AT)
(74) Vertreter: Thun, Clemens
(86) Internationale Anmeldenummer: PCT/EP2012/063181
(87) Internationale Veröffentlichungsnummer: WO 2013/020762

(56) Entgegenhaltungen:
- WO-A1-01/16524
- JP-A- 2008 221 530
- US-A1- 2009 323 330
- US-A1- 2010 165 618
- US-A1- 2010 195 330
- US-A1- 2011 103 051
- US-B1- 7 766 509

## Beschreibung

Die vorliegende Erfindung betrifft ein Lichtbeeinflussungselement, welches dazu vorgesehen ist, die Lichtabgabe von im Wesentlichen punktförmigen Lichtquellen, insbesondere von LEDs zu beeinflussen. Ferner betrifft die vorliegende Erfindung eine Leuchte mit einem derartigen Lichtbeeinflussungselement sowie ein Verfahren zur Herstellung derartiger Lichtbeeinflussungselemente.

Die fortschreitende Entwicklung von LEDs in den letzten Jahren führt dazu, dass derartige Lichtquellen zunehmend zu Beleuchtungszwecken eingesetzt werden können. Die mit Hilfe von LEDs erzielbaren Lichtstärken sind mittlerweile ausreichend hoch, so dass LEDs in nahezu sämtlichen Anwendungsgebieten bislang verwendete klassische Lichtquellen wie beispielsweise Glühbirnen, Leuchtstofflampen oder Halogenlampen ersetzen können. Ein Vorteil bei der Verwendung von LEDs besteht dabei darin, dass dieser sehr gute Möglichkeiten bieten, die Lichtabgabe zu verändern bzw. zu modifizieren. Moderne Lichtquellen auf LED-Basis bieten beispielsweise insbesondere die Möglichkeit, die Farbe oder Farbtemperatur des abgegebenen Lichts einzustellen.

Grundsätzlich strahlen LEDs Licht in einem verhältnismäßig großen Winkelbereich ab. Es ist deshalb üblich, den LEDs optische Elemente, beispielsweise kleine Reflektoren oder Linsen zuzuordnen, über welche die Lichtabgabe auf einen bestimmten Raumbereich beschränkt bzw. konzentriert wird. Hierdurch kann sichergestellt werden, dass das von der Leuchte insgesamt abgegebene Licht bei einem Beobachter keine Blendungen oder störende Reflexionen auf einer reflektierenden Oberfläche, beispielsweise einem Bildschirm oder einer Tischplatte hervorruft.

Da die Einzelanfertigung von Linsen zur Beeinflussung der Lichtabgabe mit einem extrem hohen Aufwand verbunden wäre, kommen üblicherweise Lichtbeeinflussungselemente zum Einsatz, welche aus mehreren miteinander verbundenen Linsen bestehen. Die Anordnung der Linsen ist dabei derart, dass jeder LED genau eine Linse zugeordnet ist, wobei alle Linsen das Licht der jeweiligen LED in identischer Weise beeinflussen. Derartige, vorzugsweise im Spritzgussverfahren hergestellte Lichtbeeinflussungselemente, werden dann unterhalb der LEDs angeordnet und bilden dann das bzw. ein Lichtaustrittselement der Leuchte.

Je nach Einsatzgebiet einer Leuchte sind oftmals unterschiedliche Lichtabstrahlcharakteristiken gewünscht. Üblicherweise sind die optischen Elemente einer Leuchte derart ausgelegt, dass das Licht in erster Linie symmetrisch zur Unterseite hin, insbesondere blendfrei abgegeben wird. Bei einem Einsatz in einem Geschäft oder Laden hingegen ist es oftmals erforderlich, seitlich entlang der Leuchte verlaufende Regale gezielt auszuleuchten. In diesem Fall sollte verstärkt Licht auch seitlich abgegeben werden, was in anderen Fällen eher vermieden wird, um ungewünschte Blendungen zu vermeiden. Oftmals sind auch asymmetrische Lichtabstrahlcharakteristiken gewünscht, um beispielsweise benachbarte Wände oder Objekte gezielt aufzuhellen.

WO0116524 offenbart eine Leuchte mit einer Gruppe von Lichtquellen, welche in einer ersten Ebene angeordnet sind, sowie mit einer Gruppe optischer Elemente, welche in einer zu der ersten Ebene im Wesentlichen parallelen, zweiten Ebene angeordnet sind, wobei die Position der einzelnen LEDs gegenüber dem, das Licht derselben lenkenden, optischen Element stets unterschiedlich ist. D6 offenbart nicht, dass zumindest zwei Linsen des Lichtbeeinflussungselements hinsichtlich ihrer Lichteintrittsbereiche unterschiedlich ausgebildet sind.

In US 2010/165618 A1 ist eine Leuchte offenbart, die sowohl Lichtquellen als auch optische Elemente (Lichtbeeinflussungselemente) aufweist, die miteinander so kombiniert werden, dass sie in Form unterschiedlicher Gruppen eine Lichtleiterplatte bilden, wobei die optischen Elemente jeder Gruppe so angeordnet sind, dass sie unterschiedliche Lichtstrahlformungseigenschaften aufweisen und die Gruppen einzeln adressierbar sind.

Prinzipiell wäre es denkbar, für jeden Anwendungszweck ein entsprechend individuell gestaltetes Lichtbeeinflussungselement herzustellen. Eine derartige Vorgehensweise ist allerdings mit einem extrem hohen Aufwand verbunden, da die Kosten für ein einzelnes Spritzgusswerkzeug sehr hoch sind. Eine weitere Problematik besteht auch darin, dass bei Beleuchtungssystemen, bei denen mehrere Leuchten in Längsrichtung hintereinander angeordnet sind, die Leuchten teilweise eine unterschiedliche Abstrahlcharakteristik aufweisen sollen, andererseits aber ein einheitliches Erscheinungsbild gewünscht ist. Das heißt, die Leuchten sollen zwar Licht in unterschiedlicher Weise abgeben, für einen Betrachter allerdings sollen sie zumindest sehr ähnlich aussehen.

Der vorliegenden Erfindung liegt deshalb die Aufgabenstellung zu Grunde, eine neuartige Lösung zum Erstellen geeigneter Lichtbeeinflussungselemente zur Verfügung zu stellen, welche einerseits verhältnismäßig einfach das Anpassen der Lichtabstrahlcharakteristik an eine gewünschte Verteilung ermöglicht, andererseits mit einem vertretbaren finanziellen Aufwand verbunden ist.

Die Aufgabe wird durch die in den unabhängigen Ansprüchen definierte Erfindung gelöst, vorteilhafte Weiterbildungen der Erfindung sind Gegenstand der abhängigen Ansprüche.

Der Kerngedanke der erfindungsgemäßen Lösung beruht auf der Erkenntnis, dass es möglich ist, zur Beeinflussung der Lichtabgabe Linsen einzusetzen, welche grundsätzlich im Hinblick auf ihren Lichtaustritt gleichartig ausgestaltet sind, wobei allerdings durch eine Anpassung eines Lichteintrittsbereichs der Linse die Lichtabgabe gezielt beeinflusst bzw. eine gewünschte Lichtverteilungskurve erzielt werden kann. Es handelt sich hierbei insbesondere um Linsen, deren Lichteintrittsbereich durch eine Kavität, welche dann der entsprechenden Lichtquelle zugeordnet ist, gebildet wird, wobei diese Kavität dem Lichtaustrittbereich der Linse gegenüber liegt.

Erfindungsgemäß wird dementsprechend ein Lichtbeeinflussungselement zur Beeinflussung der Lichtabgabe von im Wesentlichen punktförmigen Lichtquellen vorgeschlagen, wobei das Lichtbeeinflussungselement zumindest zwei nebeneinander angeordnete und einstückig miteinander verbundene Linsen aufweist, welche jeweils eine Kavität, welche einen Lichteintrittsbereich der Linse bildet, sowie eine dem Lichteintrittsbereich gegenüberliegende Lichtaustrittsfläche aufweisen, und wobei erfindungsgemäß zumindest zwei der Linsen hinsichtlich ihrer Lichteintrittsbereiche unterschiedlich ausgebildet sind. Ein einheitliches Erscheinungsbild ist dadurch gewährleistet, dass alle Linsen eine identisch ausgestaltete, vorzugsweise rechteckige, insbesondere quadratische Lichtaustrittsfläche aufweisen.

Der Vorteil der erfindungsgemäßen Lösung besteht darin, dass eine Modifizierung des Lichteintrittsbereichs der Linsen verhältnismäßig einfach und kostengünstig durchgeführt werden kann. Hierzu ist insbesondere vorgesehen, dass das Lichtbeeinflussungselement im Spritzgussverfahren hergestellt wird, was das Bereitstellen eines entsprechenden Spritzgusswerkzeugs erfordert. Dabei ist nunmehr allerdings vorgesehen, dass das Spritzgusswerkzeug, welches die Gesamtstruktur des Lichtbeeinflussungselements festlegt, mit einem oder mehreren Werkzeugeinsätzen versehen ist, wobei die Werkzeugeinsätze auswechselbar und/oder veränderbar in dem Spritzgusswerkzeug positionierbar sind. Diese Werkzeugeinsätze, welche im Vergleich zu dem gesamten Spritzgusswerkzeug verhältnismäßig kostengünstig in verschiedenen Varianten hergestellt werden können, definieren nunmehr die Form der Kavitäten, also der Lichteintrittsbereiche der Linsen. Durch den Austausch bzw. eine unterschiedliche Positionierung des bzw. der Einsätze können also in einfacher Weise die Eigenschaften des Lichtbeeinflussungselements angepasst bzw. modifiziert werden. Dies erlaubt es nicht nur, verschiedene Lichtbeeinflussungselemente kostengünstig herzustellen, es ist insbesondere auch möglich, dass innerhalb eines einstückig ausgebildeten Lichtbeeinflussungselements die Linsen unterschiedliche Abstrahlcharakteristiken aufweisen. Trotz allem ist der Lichtaustrittsbereich des Lichtbeeinflussungselements in allen Fällen identisch, sodass nach wie vor das gewünschte einheitliche Erscheinungsbild beibehalten wird.

Erfindungsgemäß wird also auch ein Verfahren zum Erstellen eines Lichtbeeinflussungselements vorgeschlagen, wobei das Lichtbeeinflussungselement zumindest zwei nebeneinander angeordnete und einstückig miteinander verbundene Linsen aufweist, welche jeweils eine Kavität, welche einen Lichteintrittsbereich der Linse bildet, sowie eine dem Lichteintrittsbereich gegenüberliegende Lichtaustrittsfläche aufweisen, und wobei erfindungsgemäß das Lichtbeeinflussungselement durch Spritzgießen hergestellt wird, wobei die Kavität der Linsen jeweils durch einen Werkzeugeinsatz definiert wird, welcher auswechselbar und/oder veränderbar in dem Spritzgusswerkzeug positionierbar ist. Wie bereits erwähnt, kann dabei der Werkzeugeinsatz verschieden orientiert in dem Spritzgusswerkzeug positioniert werden, wobei ergänzend oder alternativ auch die Möglichkeit besteht, unterschiedlich ausgestaltete Werkzeugeinsätze zu verwenden. Ferner bezieht sich die Erfindung auch auf ein entsprechendes Spritzgusswerkzeug.

Die Linsen des erfindungsgemäßen Lichtbeeinflussungselements sind vorzugsweise im Wesentlichen kegelstumpfartig ausgebildet, wobei - wiederum zum Erzielen eines möglichst einheitlichen Erscheinungsbilds - die Mantelflächen der Linsen identisch ausgebildet sein können. Die Kavitäten der Linsen können - je nach gewünschter Lichtabstrahlcharakteristik - einen polygonalen Querschnitt aufweisen oder rotationssymmetrisch ausgebildet sein. Eine Anpassung der Lichtabstrahlcharakteristik kann dabei insbesondere dadurch erzielt werden, dass die Bodenflächen der Kavitäten in entsprechender Weise modifiziert werden. So kann beispielsweise durch das Einbringen einer Einkerbung ein Strahlteiler realisiert werden, über den eine breitere Verteilung oder gar Aufspaltung des abgegebenen Lichts erzielt wird. Die Orientierung dieser Einkerbung kann dabei je nach Anwendungsfall auch entsprechend angepasst werden, wobei durchaus auch denkbar wäre, dass innerhalb eines einzelnen Lichtbeeinflussungselements Einkerbungen unterschiedlich orientiert sind.

Durch eine entsprechende Gestaltung des Werkzeugeinsatzes besteht insbesondere auch die Möglichkeit, die Lichtabgabe in eine bestimmte Richtung zu lenken. Sind beispielsweise die Lichteintrittsbereiche der Linsen derart gestaltet, dass eine asymmetrische Lichtabgabe erzielt wird, so kann durch eine entsprechende Anpassung der Orientierung der Linsen die Richtung der Lichtabgabe gezielt beeinflusst werden. Dies ermöglicht es, Licht gezielt zu einer bestimmten Seite hin zu richten und beispielsweise einen sog. Wallwasher zu bilden. Durch eine alternierende Anordnung entsprechend gestalteter Linsen hingegen könnte wiederum eine gleichmäßige Lichtabgabe in unterschiedliche Richtungen realisiert werden. Bei all diesen Varianten können die entsprechenden Lichtbeeinflussungselemente in verhältnismäßig einfacher und kostengünstiger Weise hergestellt werden.

Nachfolgend soll die Erfindung anhand der beiliegenden Zeichnung näher erläutert werden. Es zeigen:
- Figuren 1 und 2: Ansichten einer Leuchte, bei der erfindungsgemäß ausgestaltete und hergestellte Lichtbeeinflussungselemente zum Einsatz kommen;
- Figur 3: die Ansicht eines ersten Ausführungsbeispiels eines erfindungsgemäßen Lichtbeeinflussungselements;
- Figuren 4 und 5: Ansichten der bei dem Lichtbeeinflussungselement von Figur 3 zum Einsatz kommenden Linsen;
- Figuren 6 und 7: eine zweite Ausführungsform einer Linse;
- Figuren 8a und 8b: Lichtverteilungskurven der Linsen der Figuren 4 bis 7;
- Figur 9: die schematische Vorgehensweise zum Erzielen einer symmetrischen Lichtverteilung bei Verwendung asymmetrisch ausgestalteter Linsen;
- Figur 10: eine mögliche Variante zur gleichzeitigen Verwendung von Linsen mit asymmetrischer Lichtabgabe und
- Figur 11: eine schematische Darstellung der erfindungsgemäßen Herstellung von Lichtbeeinflussungselementen.

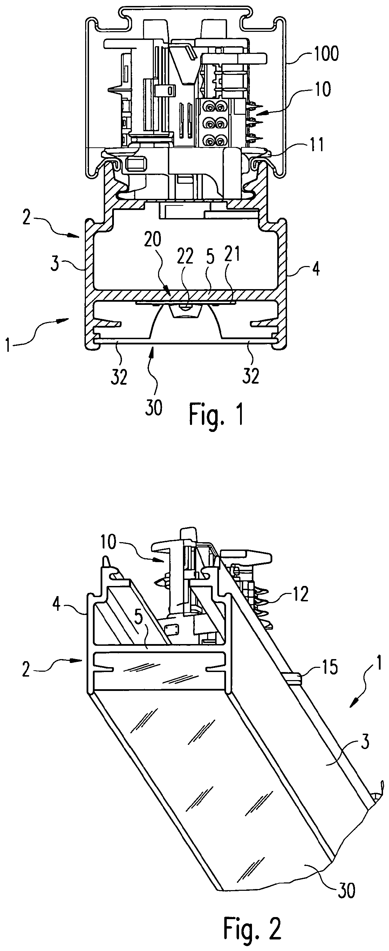

Bevor die Ausgestaltung und Herstellung der erfindungsgemäßen Lichtbeeinflussungselemente näher erläutert wird, soll zunächst ein Ausführungsbeispiel einer Leuchte beschrieben werden, bei der bevorzugt derartige Lichtbeeinflussungselemente zum Einsatz kommen. Diese in den Figuren 1 und 2 dargestellte und allgemein mit dem Bezugszeichen 1 versehene Leuchte ist eine sog. Balkenleuchte, also eine länglich ausgebildete Leuchte, die zur Verwendung in einem Stromschienensystem vorgesehen ist. Die erfindungsgemäßen Lichtbeeinflussungselemente sind allerdings keinesfalls auf den Einsatz bei derartigen Deckenleuchten beschränkt sondern können selbstverständlich auch bei anderen Leuchten zum Einsatz kommen, die nicht zum Anschluss an ein Stromschienensystem vorgesehen sind. Hierunter fallen insbesondere auch Wand- oder Stehleuchten.

Die Leuchte 1 weist zunächst als tragendes Element einen länglichen Profilkörper 2 auf, der beispielsweise als Aluminium-Strangpressprofil ausgebildet sein kann. Der Profilkörper 2 besteht aus zwei parallel zueinander verlaufenden Seitenwänden 3 und 4, welche über einen Mittelschenkel 5 miteinander verbunden sind. Im oberen Bereich des Profilkörpers 2 ist ein sog. Drehabgriff 10 verankert, der dazu dient, die mechanische Befestigung der Leuchte 1 an einer Tragschiene 100 zu ermöglichen und ferner innerhalb der Tragschiene 100 verlaufende Leitungen zu kontaktieren. Hierzu weist der Drehabgriff 10 entsprechende Vorsprünge 11 und Kontakte 12 auf, welche durch Verdrehen seitlich ausgeschwenkt werden und hierdurch Vorsprünge an der Tragschiene 100 hintergreifen bzw. in Anlage gegen entsprechende Leiter gelangen. Derartige Drehabgriffe sind bereits bekannt, wozu beispielsweise auf die DE 10 025 647 A1 der Anmelderin verwiesen wird, welche ein entsprechendes sog. Stromschienensystem beschreibt.

Als Lichtquellen kommen im vorliegenden Fall wie bereits erwähnt LEDs zum Einsatz. Hierzu sind an der Unterseite des Mittelschenkels 5 des Profilkörpers 2 in Längsrichtung hintereinander mehrere LED-Module 20 angeordnet, die jeweils eine längliche Platine 21 sowie darauf angeordnete LEDs 22 aufweisen. Bei einer Leuchte üblicher Länge sind in der Regel etwa vier bis fünf derartige LED-Module 20 in Längsrichtung hintereinander angeordnet. Die Befestigung dieser LED-Module 20 an dem Mittelschenkel 5 erfolgt vorzugsweise mittels Verkleben, wobei allerdings auch eine Schraub- oder Rastverbindung denkbar wäre. Insbesondere sollte ein guter thermischer Kontakt zwischen LED-Modul 20 und Mittelschenkel 5 vorliegen, um eine effektive Abführung der während des Betriebs der LEDs 22 auftretenden Wärme zu ermöglichen. Darauf hinzuweisen ist, dass es unter dem Begriff LEDs im vorliegenden Fall sowohl einzelne LEDs also auch LED-Cluster, beispielsweise eine RGB-Anordnung zu verstehen ist.

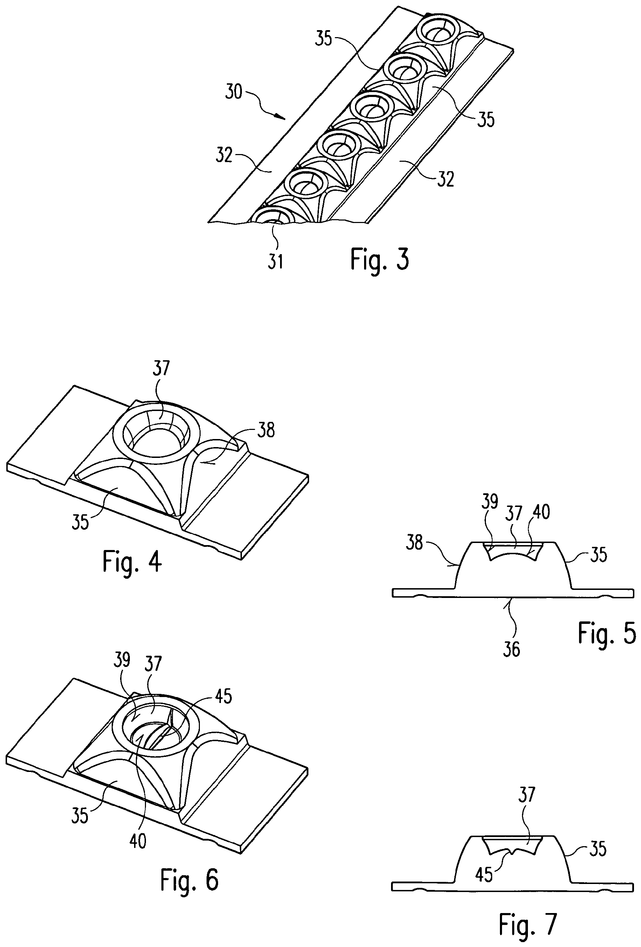

Die Abstrahlung des von den LEDs 22 emittierten Lichts erfolgt mit Hilfe eines Lichtbeeinflussungselements 30, dessen Ausgestaltung insbesondere den Figuren 3 bis 5 entnommen werden kann.

Das aus einem transparenten Kunststoffmaterial bestehende Lichtbeeinflussungselement 30 ist länglich ausgebildet und weist einen zentralen mittleren Bereich 31 auf, der durch mehrere in Längsrichtung hintereinander angeordnete Linsen 35 gebildet wird. Die Abmessungen und Anordnung der Linsen 35 sind dabei derart, dass jeder LED 22 eine eigene Linse 35 zugeordnet ist. Das einstückig ausgebildete Lichtbeeinflussungselement 30 weist vorzugsweise eine Länge auf, die einer LED-Platine 20 entspricht. Mit Hilfe zweier seitlich abstehender Arme 32, die vorzugsweise ebenfalls transparent sind, kann das Element an dem Profilkörper 2 befestigt, beispielsweise mit diesem verklemmt werden.

Die Ausgestaltung der einzelnen Linsen 35 kann insbesondere den Figuren 4 und 5 entnommen werden. Jede Linse 35 ist hierbei in etwa kegelstumpfartig ausgebildet und weist an ihrer Unterseite eine rechteckige, vorzugsweise quadratische Grundfläche auf, welche die Lichtaustrittsfläche 36 bildet und über die letztendlich die Lichtabgabe erfolgt. An der der Lichtaustrittsfläche 36 gegenüberliegenden Seite des Linsenkörpers ist eine Ausnehmung bzw. Kavität 37 ausgebildet, deren Umfangsfläche und Bodenfläche den Lichteintrittsbereich der Linse 35 bildet.

Wie der Darstellung von Figur 1 entnommen werden kann, ragt in montiertem Zustand des Lichtbeeinflussungselements 30 an dem Profilkörper 2 die LED 22 leicht in die zugehörige Kavität 37. Da das Licht der LED 22 über einen sehr breiten Winkelbereich im Wesentlichen rotationssymmetrisch abgegeben wird, wird Licht sowohl über die Bodenfläche als auch über die Mantelfläche der Kavität 37 in den Linsenkörper eingekoppelt. Ein Teil des Lichts gelangt hierbei unmittelbar zu der Lichtaustrittsfläche 36 und wird über diese abgegeben. Ein weiterer Teil des Lichts hingegen wird an der Mantelfläche 38 des kegelstumpfartigen Linsenkörpers totalreflektiert und auf diese Weise auf die Lichtaustrittsfläche 36 gelenkt.

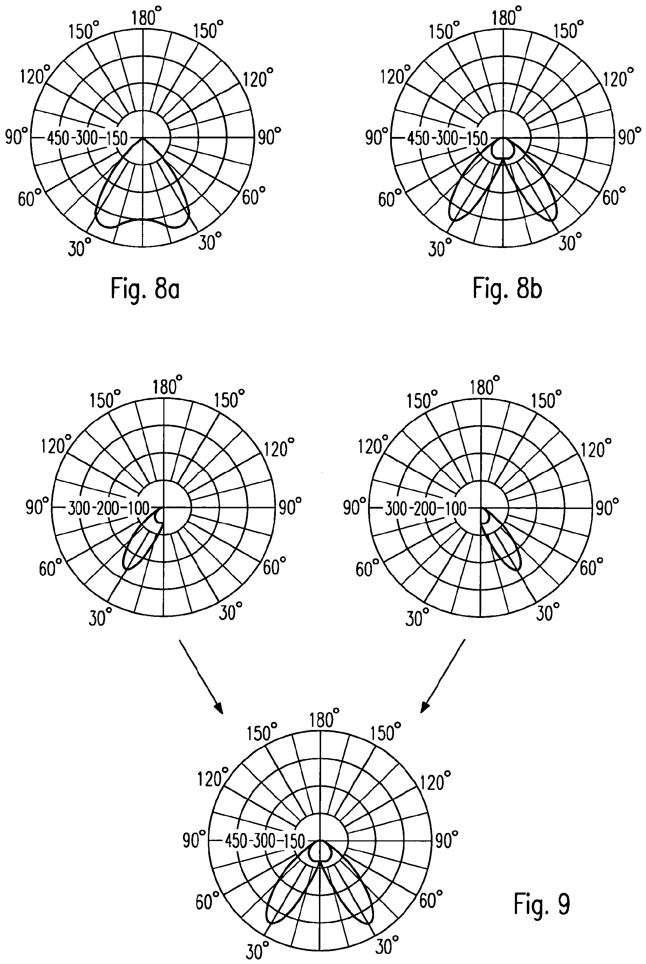

Im dargestellten Ausführungsbeispiel sind die Kavitäten 37 der Linsen 35 rotationssymmetrisch ausgebildet. Sie weisen leicht gekrümmte Seitenflächen 39 sowie eine gewölbte Bodenfläche 40 auf. Bei einer derartigen Ausgestaltung wird eine Lichtverteilung erzielt, wie sie schematisch in Figur 8a dargestellt ist. Es ist erkennbar, dass eine konzentrierte Lichtabgabe unmittelbar zur Unterseite hin erfolgt. Eine derartige Lichtabgabe ist beispielsweise erwünscht, wenn eine Blendung von Personen, die sich im Bereich der Leuchte aufhalten, unter flachen Blickwinkeln vermieden werden soll.

Wird hingegen die Leuchte im Geschäftsbereich, beispielsweise zwischen zwei parallel zueinander verlaufenden Regalreihen- oder wänden eingesetzt, so ist oftmals eher eine Lichtverteilung gewünscht, wie sie schematisch in Figur 8b dargestellt ist. In diesem Fall soll also weniger Licht unmittelbar nach unten abgegeben sondern vermehrt in zwei einander gegenüberliegende seitliche Bereiche abgestrahlt werden.

Zur Realisierung einer derartigen anderen Lichtverteilungskurve war es bislang erforderlich, ein vollständig neues Lichtbeeinflussungselement zu entwickeln. Die Herstellung eines entsprechenden eigenen Spritzgusswerkzeugs hierfür war allerdings mit einem sehr hohen Kostenaufwand verbunden.

Erfindungsgemäß wird nunmehr eine Lösung vorgeschlagen, welche das Anpassen der Lichtverteilungscharakteristik deutlich vereinfacht. Diese Lösung beruht auf der Erkenntnis, dass insbesondere durch eine entsprechende Gestaltung des Lichteintrittsbereichs der Linsen 35 die Lichtverteilung in gewünschter Weise angepasst werden kann. Die weiteren Elemente der Linse 35 hingegen, insbesondere die Lichtaustrittsfläche 36 sowie die Mantelfläche 38 des Linsenkörpers müssen nicht verändert werden. Dies führt einerseits zu dem Vorteil, dass auch bei unterschiedlicher Lichtabstrahlcharakteristik das Erscheinungsbild des Lichtbeeinflussungselements unverändert bleibt. Ferner ist die Herstellung eines entsprechend gestalteten Lichtbeeinflussungselements mit veränderter Lichtverteilungskurve nunmehr deutlich kostengünstiger.

Bevor das Verfahren zur Herstellung des Lichtbeeinflussungselements 30 näher erläutert wird, soll zunächst eine Linse 35 gezeigt werden, mit der die in Figur 8b gezeigte Lichtverteilungscharakteristik erzielt wird. Diese in den Figuren 6 und 7 dargestellte Linse 35 zeichnet sich dadurch aus, dass die Kavität 37 des Lichteintrittsbereichs eine Einkerbung 45 aufweist. Wie zu erkennen ist, erstreckt sich diese Einkerbung 45 sowohl durch die Bodenfläche 40 als auch durch die Umfangsfläche 39 der Kavität 37. Durch diese Einkerbung 45 wird ein Strahlteiler realisiert, der das auftreffende Licht, welches an sich ungehindert zur Unterseite hin abgegeben wird, seitlich auslenkt bzw. aufspaltet, so dass letztendlich die angestrebte symmetrische, seitliche Lichtabstrahlung gemäß Figur 8b erzielt wird.

Eine weitere Möglichkeit besteht auch darin, den Lichteintrittsbereich einer Linse derart auszugestalten, dass eine asymmetrische Lichtabgabe erzielt wird, wie sie beispielsweise schematisch im oberen linken Bereich von Figur 9 dargestellt ist. Auch eine derartige Lichtabstrahlcharakteristik kann durch eine entsprechende Anpassung der Kavität bzw. dem Lichteintrittsbereich der Linse erzielt werden, ohne dass hierfür der Lichtaustrittsbereich oder die Form der Mantelfläche des Linsenkörpers angepasst werden müssten. Werden ausschließlich derartige asymmetrisch gestaltete Linsen verwendet, so wird das Licht ausschließlich in den linken unteren Bereich seitlich abgestrahlt und kann beispielsweise dazu genutzt werden, einen dort befindlichen Wandbereich oder ein Objekt auszuleuchten. Eine Leuchte mit einen derartigen Lichtbeeinflussungselement könnte also als sog. Wallwasher verwendet werden, wobei sie allerdings zunächst für einen Betrachter von einer Leuchte, welche eine Lichtabstrahlcharakteristik gemäß Figur 8a oder 8b aufweist, nicht zu unterscheiden ist, da die Lichtbeeinflussungselemente 30 hinsichtlich ihres Lichtaustrittsbereichs grundsätzlich identisch ausgestaltet sind. In gleicher Weise könnte selbstverständlich auch die Ausgestaltung der Linse derart erfolgen, dass das Licht zur rechten unteren Seite abgegeben wird, wie im rechten oberen Bereich von Figur 9 gezeigt ist.

Werden nunmehr allerdings innerhalb eines Lichtbeeinflussungselements alternierend Linsen eingesetzt, welche einerseits primär nach links und andererseits primär nach rechts abstrahlen, so wird insgesamt eine Lichtstrahlcharakteristik erzielt, wie sie im unteren Bereich von Figur 9 gezeigt ist. Es wird also wiederum eine zu beiden Seiten symmetrisch abstrahlende Lichtverteilungskurve, die im Wesentlichen derjenigen von Figur 8b entspricht, erzielt.

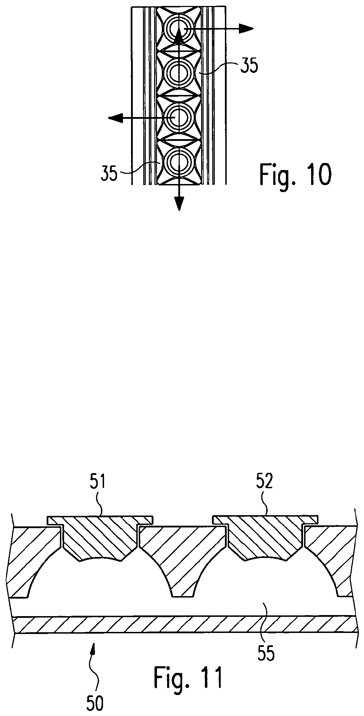

Eine weitere Möglichkeit eines sinnvollen Lichtbeeinflussungselements ist in Figur 10 dargestellt. Hier sind aufeinanderfolgende Linsen 35 jeweils derart ausgebildet, dass die asymmetrische Lichtabgabe - schematisch mit einem Pfeil angedeutet ist - jeweils um 90° verdreht wird. In Kombination wird hierdurch eine Lichtabgabe in sämtliche vier Hauptrichtungen erzielt. Ferner wäre es auch denkbar, die zur asymmetrischen Lichtabgabe ausgebildeten Linsen derart zu orientieren, dass die Lichtabgabe entlang der Längsrichtung der Leuchte erfolgt. Hierdurch könnte ein Objekt oder eine Wand in einem Stirnbereich einer Leuchte gezielt beleuchtet werden. Ein geeignetes Anwendungsgebiet hierfür wäre beispielsweise eine sog. Tafelbeleuchtung, wobei hierfür auf zusätzliche, senkrecht zur allgemeinen Beleuchtung ausgerichtete Leuchten verzichtet werden könnte.

All diese Ausführungsbeispiele verdeutlichen, dass die Herstellung individuell gestalteter Lichtbeeinflussungselement äußerst wünschenswert ist. Eine Herstellung in der bislang bekannten Weise, also im klassischen Spritzgußverfahren, wäre allerdings aus finanziellen Gründen kaum realisierbar, da für jede Variante ein eigenes Spritzgußwerkzeug bereit gestellt werden müsste, was zu sehr hohen Kosten führen würde.

Wie bereits erwähnt besteht jedoch ein wesentlicher Vorteil der erfindungsgemäßen Lösung auch darin, dass die unterschiedlich ausgestalteten Linsen in sehr einfacher Weise realisiert und hergestellt werden können. Dieser Vorteil beruht darauf, dass die Gestaltung des Lichteintrittsbereichs der Linse sehr einfach verändert bzw. modifiziert werden kann, sofern der weitere Bereich des Linsenkörpers im Wesentlichen unverändert bleibt.

Erfindungsgemäß ist deshalb vorgesehen, dass das Lichtbeeinflussungselement wiederum im Rahmen eines sog. Spritzgussverfahrens hergestellt wird, bei dem also flüssiger Kunststoff in ein Spritzgusswerkzeug eingeleitet wird und dort erstarrt. Der Hohlraum des Werkzeugs entspricht der späteren Gestalt des Lichtbeeinflussungselements, wobei nunmehr allerdings vorgesehen ist, Werkzeugeinsätze zu verwenden, durch welche die Formgebung der Lichteintrittsbereiche der Linsen erfolgt.

Dieser Gedanke ist schematisch in Figur 11 dargestellt, welche im Querschnitt schematisch ein Spritzgusswerkzeug 50 zeigt, welches den Hohlraum 55 zur Erstellung des Lichtbeeinflussungselements bildet. Der Hohlraum 55 wird dabei im Wesentlichen durch das Spritzgusswerkzeug 50 definiert, wobei allerdings zusätzlich unterschiedlich positionierbare und/oder auswechselbare Stempel bzw. Werkzeugeinsätze 51, 52 vorgesehen sind. Diese Stempel oder Einsätze 51, 52 werden derart in dem Werkzeug 50 positioniert, dass sie den Hohlraum 55, der durch das Kunststoffmaterial gefüllt werden soll, in dem Bereich begrenzen, der die spätere Kavität, also den Lichteintrittsbereich für die zugehörige Linse bildet. Im Vergleich zu dem gesamten Spritzgusswerkzeug 50 sind derartige Einsätze 51, 52 verhältnismäßig kostengünstig herzustellen, wobei nunmehr wahlweise das Werkzeug 50 mit unterschiedlichen Einsätzen 51 oder 52 bestückt werden kann, um beispielsweise Linsen herzustellen, wie sie in den Figuren 3 bis 5 dargestellt sind, oder Linsen entsprechend den Darstellungen der Figuren 6 und 7.

D.h., ausgehend von einer Lichtabstrahlcharakteristik, wie sie in Figur 8a dargestellt ist, kann sehr einfach auf eine Abstrahlcharakteristik beispielweise gemäß Figur 8b gewechselt werden, indem die Stempel bzw. Einsätze 51, 52 im Werkzeug ausgetauscht werden, so dass der Lichteintrittsbereich der Linsen angepasst und mit der kerbenartigen Vertiefung versehen wird. Das äußere Erscheinungsbild der Linsen, insbesondere Größe und Form bleiben unverändert, es wird jedoch eine deutlich veränderte Abstrahlcharakteristik erzielt.

Auch Einsätze, über die eine asymmetrische Lichtabgabe erzielt wird, wären denkbar, wobei in diesem Fall dann auch vorgesehen sein kann, dass derartige Einsätze in unterschiedlicher Orientierung in dem Werkzeug 50 angeordnet werden, um - wie im Zusammenhang mit den Figuren 9 und 10 erläutert - jeweils eine Lichtabgabe in unterschiedlicher Richtung zu erzielen.

Es ist ersichtlich, dass bei einer derartigen Vorgehensweise in einfacher Weise Lichtbeeinflussungselemente mit einer speziellen gewünschten Lichtabstrahlcharakteristik erhalten werden können. Dabei ist insbesondere auch denkbar, dass die einzelnen Linsen eines einstückig ausgebildeten Lichtbeeinflussungselements unterschiedlich gestaltet sind. In diesem Fall kann eine sehr individuelle Anpassung der Lichtabstrahlcharakteristik des gesamten Lichtbeeinflussungselements erzielt werden, wobei hierfür nicht das Bereitstellen eines speziell dafür vorgesehenen Spritzgusswerkzeugs erforderlich ist. Es ist ersichtlich, dass eine derartige Lösung sehr kostenfreundlich ist.

Auch für den Fall allerdings, dass die Linsen eines einzelnen Lichtbeeinflussungselements grundsätzlich identisch ausgestaltet sind, werden Kostenvorteile erzielt, da auch in diesem Fall in einfacher Weise unterschiedlich ausgestaltete Lichtbeeinflussungselemente hergestellt werden können. Somit wäre es ohne Weiteres möglich, bei einer Leuchte gemäß den Figuren 1 und 2 fast über die gesamte Länge hinweg die gleichen Lichtbeeinflussungselemente zu verwenden, welche beispielsweise eine seitliche Lichtabstrahlung bewirken, am Stirnende jedoch ein Lichtbeeinflussungselement anzuordnen, durch das eine Lichtabgabe in Längsrichtung erzielt wird. Neben einer kostengünstigen Herstellung der verschiedenen Lichtbeeinflussungselemente wird dabei auch der Vorteil erzielt, dass die Lichtbeeinflussungselemente ein einheitliches Erscheinungsbild aufweisen.

## Patentansprüche

1. Lichtbeeinflussungselement (30) zur Beeinflussung der Lichtabgabe von im Wesentlichen punktförmigen Lichtquellen (22),
wobei das Lichtbeeinflussungselement (30) zumindest zwei nebeneinander angeordnete und einstückig miteinander verbundene Linsen (35) aufweist, welche jeweils
a) eine Kavität (37), welche einen Lichteintrittsbereich der Linse (35) bildet, sowie
b) eine dem Lichteintrittsbereich gegenüberliegende Lichtaustrittsfläche (36) aufweisen,
**dadurch gekennzeichnet,**
**dass** zumindest zwei der Linsen (35) hinsichtlich ihrer Lichteintrittsbereiche unterschiedlich ausgebildet sind, wobei alle Linsen (35) identisch ausgestaltete Lichtaustrittsflächen (36) aufweisen.

2. Lichtbeeinflussungselement nach Anspruch 1,
**dadurch gekennzeichnet,**
**dass** alle Linsen (35) rechteckige, insbesondere quadratische Lichtaustrittsflächen (36) aufweisen.

3. Lichtbeeinflussungselement nach Anspruch 1 oder 2,
**dadurch gekennzeichnet,**
**dass** die Linsen (35) im Wesentlichen kegelstumpfartig ausgebildet sind, wobei die Mantelflächen (38) der Linsen (35) identisch ausgebildet sind.

4. Lichtbeeinflussungselement nach einem der vorherigen Ansprüche,
**dadurch gekennzeichnet,**
**dass** die Kavitäten (37) zumindest einiger Linsen (35) einen polygonalen Querschnitt aufweisen.

5. Lichtbeeinflussungselement nach einem der vorherigen Ansprüche,
**dadurch gekennzeichnet,**
**dass** die Kavitäten (37) zumindest einiger Linsen (35) rotationssymmetrisch ausgebildet sind.

6. Lichtbeeinflussungselement nach einem der vorherigen Ansprüche,
**dadurch gekennzeichnet,**
**dass** die Kavitäten (37) der unterschiedlich ausgebildeten Linsen (35) sich in der Ausgestaltung der Bodenfläche (40) unterscheiden.

7. Lichtbeeinflussungselement nach Anspruch 6,
**dadurch gekennzeichnet,**
**dass** die Bodenfläche (40) zumindest einer der Kavitäten (37) eine Einkerbung (45) aufweist.

8. Lichtbeeinflussungselement nach Anspruch 7,
**dadurch gekennzeichnet,**
**dass** mehrere Linsen (35) eine Einkerbung (45) aufweisen, welche unterschiedlich orientiert sind.

9. Leuchte (1) mit mehreren nebeneinander angeordneten, im Wesentlichen punktförmigen Lichtquellen (22) sowie einem den Lichtquellen (22) zugeordneten Lichtbeeinflussungselement (30) nach einem der vorherigen Ansprüche.

10. Verfahren zum Erstellen eines Lichtbeeinflussungselements (30), welches zumindest zwei nebeneinander angeordnete und einstückig miteinander verbundene Linsen (35) aufweist, welche jeweils
a) eine Kavität (37), welche einen Lichteintrittsbereich der Linse (35) bildet, sowie
b) eine dem Lichteintrittsbereich gegenüberliegende Lichtaustrittsfläche (36) aufweisen,
**dadurch gekennzeichnet,**
**dass** das Lichtbeeinflussungselement (30) durch Spritzgießen hergestellt wird, wobei die Kavitäten (37) der Linsen (35) jeweils durch einen Werkzeugeinsatz (51, 52) definiert werden, der auswechselbar und/oder verschieden orientierbar in dem Spritzgußwerkzeug (50) positionierbar ist.

11. Lichtbeeinflussungselement (30), welches entsprechend dem Verfahren nach Anspruch 10 hergestellt wird.

12. Spritzgußwerkzeug zum Erstellen eines Lichtbeeinflussungselements (30), welches zumindest zwei nebeneinander angeordnete und einstückig miteinander verbundene Linsen (35) aufweist, welche jeweils
a) eine Kavität (37), welche einen Lichteintrittsbereich der Linse (35) bildet, sowie
b) eine dem Lichteintrittsbereich gegenüberliegende Lichtaustrittsfläche (36) aufweisen,
**dadurch gekennzeichnet,**
**dass** das Spritzgußwerkzeug Werkzeugeinsätze enthält, und
**dass** die Kavität (37) jeder Linse (35) jeweils durch einen Werkzeugeinsatz (51, 52) definiert wird, der auswechselbar und/oder verschieden orientierbar in dem Spritzgußwerkzeug (50) positionierbar ist.

13. Verfahren zum Anpassen der Lichtabstrahlcharakteristik eines mit Hilfe eines Spritzgußwerkzeugs hergestellten Lichtbeeinflussungselements (30), welches zumindest zwei nebeneinander angeordnete und einstückig miteinander verbundene Linsen (35) aufweist, welche jeweils
a) eine Kavität (37), welche einen Lichteintrittsbereich der Linse (35) bildet, sowie
b) eine dem Lichteintrittsbereich gegenüberliegende Lichtaustrittsfläche (36) aufweisen,
**dadurch gekennzeichnet,**
**dass** die Kavität (37) jeder Linse (35) jeweils durch einen Werkzeugeinsatz (51, 52) definiert wird, der auswechselbar und/oder verschieden orientierbar in dem Spritzgußwerkzeug (50) positionierbar ist,
wobei die Lichtabstrahlcharakteristik des Lichtbeeinflussungselements (30) durch Auswechseln und/oder Repositionieren der Werkzeugeinsätze angepasst wird.

## Claims

1. A light-influencing element (30) for influencing the light emission of essentially punctiform light sources (22),
wherein the light-influencing element (30) has at least two lenses (35) arranged side-by-side and connected together in one piece, which in each case have
a) a cavity (37), which forms a light entrance section of the lens (35), as well as
b) a light exit surface (36) opposite the light entrance section,
**characterized in**
**that** at least two of the senses (35) are designed differently with regard to their light entrance sections, wherein all lenses (35) have identically designed light exit surfaces (36).

2. A light-influencing element according to Claim 1,
**characterized in**
**that** all lenses (35) have rectangular, in particular, square light exit surfaces (36).

3. A light-influencing element according to Claim 1 or 2,
**characterized in**
**that** the lenses (35) are designed essentially truncated cone-shaped, wherein the lateral surfaces (38) of the lenses (35) are identically designed.

4. A light-influencing element according to any one of the preceding claims,
**characterized in**
**that** the cavities (37) at least of some lenses (35) have a polygonal cross section.

5. A light-influencing element according to any one of the preceding claims,
**characterized in**
**that** the cavities (37) at least of some lenses (35) are designed rotationally symmetrically.

6. A light-influencing element according to any one of the preceding claims,
**characterized in**
**that** the cavities (37) of differently designed lenses (35) differ in the design of the bottom surface (40).

7. A light-influencing element according to Claim 6,
**characterized in**
**that** the bottom surface (40) at least of one of the cavities (37) has a notch (45).

8. A light-influencing element according to Claim 7,
**characterized in**
**that** several lenses (35) have a notch (45), which are oriented differently.

9. A lamp (1) with several essentially punctiform light sources (22) arranged side-by-side as well as a light-influencing element (30) associated with the light sources (22) according to any one of the preceding claims.

10. A method for creating a light-influencing element (30), which has at least two lenses (35) arranged side-by-side and connected together in one piece, which in each case have
a) a cavity (37), which forms a light entrance section of the lens (35), as well as
b) a light exit surface (36) opposite the light entrance section,
**characterized in**
**that** the light-influencing element (30) is produced by injection molding, wherein the cavities (37) of the lenses (35) are defined in each case by a tool insert (51, 52), which can be positioned interchangeably and/or differently orientable in the injection molding tool (50).

11. A light-influencing element (30), which is produced according to the method according to Claim 10.

12. An injection molding tool for creating a light-influencing element (30), which has at least two lenses (35) arranged side-by-side and connected together in one piece, which in each case have
a) a cavity (37), which forms a light entrance section of the lens (35), as well as
b) a light exit surface (36) opposite the light entrance section,
**characterized in**
**that** the injection molding tool contains tool inserts, and
**that** the cavity (37) of each lens (35) is defined in each case by a tool insert (51, 52), which can be positioned interchangeably and/or differently orientable in the injection molding tool (50).

13. A method for adjusting the light-emitting characteristic of a light-influencing element (30) produced with the aid of an injection molding tool, which light-influencing element has at least two lenses (35) arranged side-by-side and connected together in one piece, which in each case have
a) a cavity (37), which forms a light entrance section of the lens (35), as well as
b) a light exit surface (36) opposite the light entrance section,
**characterized in**
**that** the cavity (37) of each lens (35) is defined in each case by a tool insert (51, 52), which can be positioned interchangeably and/or differently orientable in the injection molding tool (50),
wherein the light-emitting characteristic of the light-influencing element (30) is adjusted by interchanging and/or repositioning the tool inserts.

## Revendications

1. Elément influençant la lumière (30) destiné à influer sur l'émission de lumière de sources de lumière (22) essentiellement ponctuelles,
l'élément influençant la lumière (30) comportant au moins deux lentilles (35), disposées de façon juxtaposée et raccordées l'une à l'autre en formant une seule pièce, lesquelles comportent respectivement
a) une cavité (37) qui forme une zone d'entrée de lumière de la lentille (35), ainsi que
b) une surface de sortie de lumière (36) en face de la zone d'entrée de lumière,
**caractérisé en ce**
**qu'**au moins deux des lentilles (35) sont constituées de façon différente en ce qui concerne leurs zones d'entrée de lumière, toutes les lentilles (35) comportant des surfaces de sortie de lumière (36) constituées de façon identique.

2. Elément influençant la lumière selon la revendication 1,
**caractérisé en ce que**
toutes les lentilles (35) comportent des surfaces de sortie de lumière (36) rectangulaires, en particulier carrées.

3. Elément influençant la lumière selon la revendication 1 ou 2,
**caractérisé en ce que**
les lentilles (35) sont constituées essentiellement avec une forme tronconique, les surfaces d'enveloppe (38) des lentilles (35) étant constituées de façon identique.

4. Elément influençant la lumière selon l'une des revendications précédentes,
**caractérisé en ce que**
les cavités (37) d'au moins quelques lentilles (35) comportent une section transversale polygonale.

5. Elément influençant la lumière selon l'une des revendications précédentes,
**caractérisé en ce que**
les cavités (37) d'au moins quelques lentilles (35) sont constituées avec une symétrie de révolution.

6. Elément influençant la lumière selon l'une des revendications précédentes,
**caractérisé en ce que**
les cavités (37) des lentilles (35) constituées de façon différente se distinguent par la constitution de la surface de fond (40).

7. Elément influençant la lumière selon la revendication 6,
**caractérisé en ce que**
la surface de fond (40) d'au moins une des cavités (37) comporte une encoche (45).

8. Elément influençant la lumière selon la revendication 7,
**caractérisé en ce que**
plusieurs lentilles (35) comportent une encoche (45) qui sont orientées de façon différente.

9. Luminaire (1) avec plusieurs sources de lumière (22) disposées de façon juxtaposée, essentiellement ponctuelles, ainsi qu'avec un élément influençant la lumière (30) affecté aux sources de lumière (22) selon l'une des revendications précédentes.

10. Procédé de création d'un élément influençant la lumière (30) qui comporte au moins deux lentilles (35), disposées de façon juxtaposée et raccordées l'une à l'autre en formant une seule pièce, lesquelles comportent respectivement
a) une cavité (37) qui forme une zone d'entrée de lumière de la lentille (35), ainsi que
b) une surface de sortie de lumière (36) en face de la zone d'entrée de lumière,
**caractérisé en ce que**
l'élément influençant la lumière (30) est fabriqué par moulage par injection, les cavités (37) des lentilles (35) étant définies respectivement par un insert d'outil (51, 52) qui peut être remplacé et/ou positionné avec une orientation différente dans l'outil de moulage par injection (50).

11. Elément influençant la lumière (30) qui est fabriqué conformément au procédé selon la revendication 10.

12. Outil de moulage par injection destiné à la création d'un élément influençant la lumière (30) qui comporte au moins deux lentilles (35), disposées de façon juxtaposée et raccordées l'une à l'autre en formant une seule pièce, lesquelles comportent respectivement
a) une cavité (37) qui forme une zone d'entrée de lumière de la lentille (35), ainsi que
b) une surface de sortie de lumière (36) en face de la zone d'entrée de lumière,
**caractérisé en ce que**
l'outil de moulage par injection contient des inserts d'outil, et **en ce que** la cavité (37) de chaque lentille (35) est définie par un insert d'outil (51, 52) qui peut être remplacé et/ou positionné avec une orientation différente dans l'outil de moulage par injection (50).

13. Procédé destiné à l'adaptation de la caractéristique de rayonnement de lumière d'un élément influençant la lumière (30), fabriqué à l'aide d'un outil de moulage par injection, qui comporte au moins deux lentilles (35), disposées de façon juxtaposée et raccordées l'une à l'autre en formant une seule pièce, qui comportent respectivement
a) une cavité (37) qui forme une zone d'entrée de lumière de la lentille (35), ainsi que
b) une surface de sortie de lumière (36) en face de la zone d'entrée de lumière,
**caractérisé en ce que**
la cavité (37) de chaque lentille (35) est définie respectivement par un insert d'outil (51, 52) qui peut être remplacé et/ou positionné avec une orientation différemment dans l'outil de moulage par injection (50),
la caractéristique de rayonnement de lumière de élément influençant la lumière (30) étant adaptée par le remplacement et/ou le repositionnement des inserts d'outils.
